(19) Europäisches Patentamt / European Patent Office / Office européen des brevets

(11) **EP 4 604 024 A1**

(12) **EUROPEAN PATENT APPLICATION**

(43) Date of publication:
**20.08.2025 Bulletin 2025/34**

(21) Application number: **25154262.7**

(22) Date of filing: **27.01.2025**

(51) International Patent Classification (IPC):
**G06N 5/01** $^{(2023.01)}$ **G06N 7/01** $^{(2023.01)}$
**G06N 20/00** $^{(2019.01)}$ **G06F 30/27** $^{(2020.01)}$

(52) Cooperative Patent Classification (CPC):
**G06N 20/00; G06F 30/27; G06N 5/01; G06N 7/01**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.02.2024 US 202418441672**

(71) Applicant: **General Electric Company
Cincinnati, Ohio 45215 (US)**

(72) Inventors:
• **PANDITA, Piyush**
  **Niskayuna (US)**
• **GHOSH, Sayan**
  **Niskayuna (US)**
• **FOSTER, Chad**
  **West Chester (US)**
• **WANG, Liping**
  **Niskayuna (US)**

(74) Representative: **Openshaw & Co.
8 Castle Street
Farnham, Surrey GU9 7HR (GB)**

(54) **INTELLIGENT SELECTION OF INPUTS FOR RAPID INFERENCE AND QUANTIFICATION OF UNCERTAINTY FOR ACTIVE LEARNING**

(57) A system (100) for intelligent selection of inputs for inference and quantification of uncertainty for active learning in a model includes computing an information gain by combining one or more metrics of interest and uncertainties in the inputs using information compression based on a first set of data as one or more pairs of values of inputs and outputs. One or more of the inputs are selected, with a potential information gain higher than other inputs, to query the model and record values of one or more of the outputs. The model computes a measurement of performance outputs based upon the first set of data. The model is updated based upon estimated metrics of interest performance and quantification of the associated uncertainty, and output for a change to a process based upon the estimated metrics of interest performance and quantification of the associated uncertainty.

FIG. 4

**EP 4 604 024 A1**

**Description**

TECHNICAL FIELD

The present disclosure relates to selecting inputs for active learning. Particularly, the present disclosure relates to a system and a method for intelligent selection of inputs for rapid inference and quantification of uncertainty for arbitrary statistics of expensive functions using active learning.

BACKGROUND

Many applications make use of performance estimation systems to forecast part longevity based on usage. Accordingly, an estimation of part failure may be determined. Typical measuring systems require large amounts of information and require expensive experiments to perform estimation.

BRIEF DESCRIPTION OF THE DRAWINGS

Illustrative embodiments may take form in various components and arrangements of components. Illustrative embodiments are shown in the accompanying drawings, throughout which like reference numerals may indicate corresponding or similar parts in the various drawings. The drawings are only for purposes of illustrating the embodiments and are not to be construed as limiting the disclosure. Given the following enabling description of the drawings, the novel aspects of the present disclosure should become evident to a person of ordinary skill in the relevant art(s).

Figure 1 illustrates a system according to an exemplary embodiment.
Figure 2 is a block diagram of a device of the system of Figure 1, in accordance with one embodiment;
Figure 3 is a flow diagram of a machine learning network method, in accordance with one embodiment; and
Figure 4 is a flow diagram of a method of performing rapid inference and quantification, in accordance with one embodiment.

DETAILED DESCRIPTION

Prior to discussing the drawings of the present disclosure at length, several terms and concepts are covered in order to facilitate the detailed description of the exemplary embodiments depicted in the drawings. It is noted that however that these terms and concepts do not limit the disclosure and that one of ordinary skill in the relevant art(s) will readily recognize modifications and changes applicable to the following ancillary systems and/or concepts that do not limit the scope of the present teachings.

In order to predict component failures, such as turbine failure, wing failure, and the like, various statistics may need to be analyzed. In some example embodiments, the statistics that need to be learned and analyzed may include statistics of a physical quantity like aerodynamic efficiency, maximum principal stress, area of spall, etc., that may be modeled as a complex and expensive computer model or a physical experiment with real-valued parameters or inputs, while using a finite number of data points.

Conventional methods for inferring the statistics above that are of interest in performing predictions involve expensive experiments, including potentially thousands of experimental runs, and computer code that include uncertainty in the statistics (e.g., manufacturing tolerances in the inputs, or noise in the measurements of the outputs). These uncertainties may affect the inferred value of the statistics. Accordingly, by accurately quantifying input uncertainty to the machine learning model, such as manufacturing tolerances, and/or design uncertainty, one can obtain less costly and more productive data in order to infer metrics of interest for example, the statistical expectation, tail probabilities, extreme values of the underlying physical response, etc.

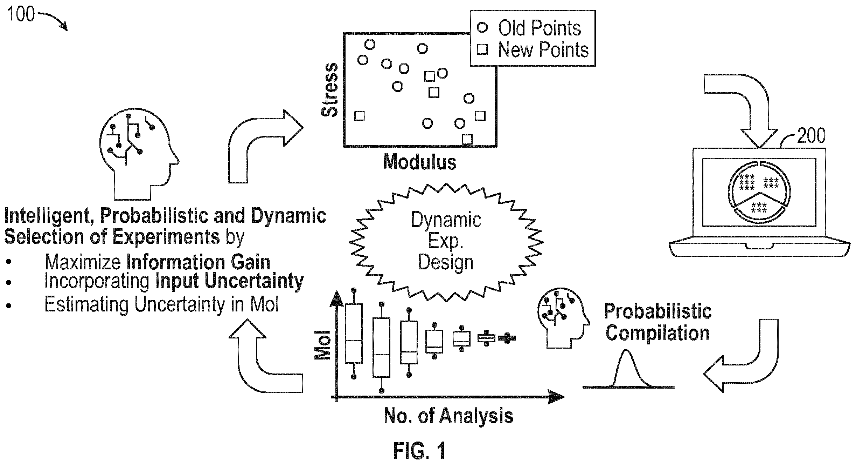

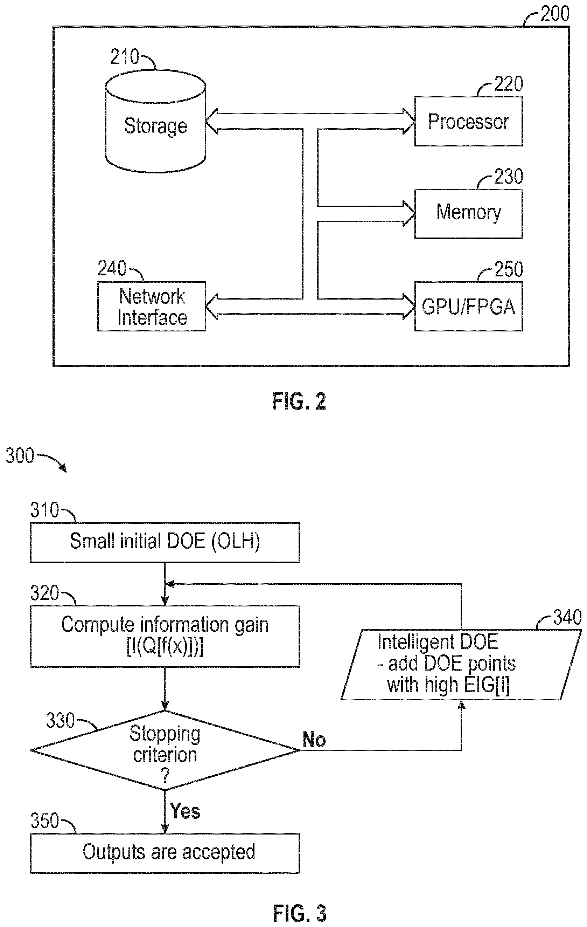

Figure 1 illustrates a system 100 according to an exemplary embodiment. The system 100 includes a device 200, which will be described below in Figure 2. As shown in Figure 1, intelligent, probabilistic and dynamic selection of experiments includes maximizing information gain, incorporating input uncertainty and estimating metrics of interest (MOI) as well as quantifying uncertainties in these estimates. In various embodiments, data points may be utilized (e.g., old points and new points) and input into the device 200. In various embodiments, information gain may include a measurement of how much entropy is reduced when a dataset is split, for example, by comparing the entropy of the dataset before and after an augmentation of the dataset.

In various embodiments, the system 100 described herein may be applicable to any expensive experiment such as combustion tests that measure outputs like temperature and pressure, and input parameters like fuel burn, flow rate etc., as well as cases where a physical process is modeled as a complex expensive-to-compute computational model. In various embodiments, for example, the design of a turbine blade using a computational model may be used. For example, the system 100 may be applicable to design of high pressure turbine blades (airfoil design) using a computational fluid dynamics model.

The high pressure turbine (HPT) of a jet engine consists of several stages of blades (also called airfoils). The design of the shape of these blades in order to achieve critical values of key metrics like max. value of the pressure distribution, tail value of rated efficiency, etc., may be important metrics to aid in the design of the blades.

In various embodiments, the shape of the blade may be mapped to a finite number of parameters, for example, height of the airfoil, width of the airfoil, etc. The underlying complex physics associated with the blade design may be represented with sophisticated mathematical equations. For example, engineers and scientists may program these complex methods using computer codes that are accurate in modeling the underlying physical process albeit at an extremely high computational cost. For instance, to run one simulation using, for example, large eddy simulation methods could take several days of computations.

In order to investigate the effect of the shape parameters on the pressure distribution and efficiency and obtain critical metrics like max values or tail values of these outputs, one might need to query this code at hundreds or thousands of parameter combinations. Accordingly, even parallel computing may not allow full exploration of the input space to determine the parameters that are optimal for a designer's requirements.

In addition, there may be uncertainty on the values of the input parameters. In various embodiments, this uncertainty may be characterized by an upper and lower bound on a nominal value of the parameter. In the physical sense, the uncertainty around the nominal values represents the unknown effects of environmental factors, imperfections in the manufacturing process, operational uncertainty etc.

Accordingly, in various example embodiments, described herein may provide optimal and efficient allocation of computational resources while aiming to learn the optimal values of the metrics of the outputs, while incorporating and quantifying the effects of the uncertainties in the input parameters on the metrics.

Additionally, the methods and system described herein may be utilized for any computer aided analysis (CFD, FEA etc.) where obtaining an optimal design along candidates of equally optimal solutions for extreme tail probability value of the max. stress, and/or other outputs of the FEA, including uncertainty within reasonable CPU time (so it is affordable).

Accordingly, in various embodiments, the methods and system described herein may be applied to any robust design application where metrics like max or min of code outputs like stress, force, pressure, displacement, temperature, displacement, vibrations, flow rates, heat transfer rates, lifing are of interest and there is variation in the inputs (e.g., to the CAE simulation).

The device 200 in various embodiments may utilize a machine learning model in order to run experiments, (e.g., training iterations) in order to produce a probabilistic compilation of results that produce more accurate predictions with each iteration. For example, as shown in Figure 1, MOIs graphed against number of analysis produce more accurate estimates with less uncertainty with each iteration. The machine learning model utilizes the learned data to increase accuracy with each iteration.

In various embodiments, input data may include, design parameters, and/or process parameters and prior available information about them. Prior information may include manufacturing or operation uncertainty or it may include material constants, and/or stress distributions. MOIs, in various embodiments, may include statistics on performance and/or manufacturing (e.g., efficiency, variances in weight, variances in fuel consumption, etc.).

In various embodiments, described herein is a method for estimating key statistics of MOIs (e.g., related to tail probabilities, failure probabilities, quantities, reliability, risk, and uncertainty quantification). In various embodiments, the information gain is estimated in user-defined multivariate statistics of MOIs to intelligently and adaptively select design points to run experiments.

In various embodiments, data such as input uncertainties (e.g., manufacturing tolerances, noise measurements, etc.) is incorporated and the uncertainty on the statistics as MOIs is estimated to define intervals around the inferred value of the statistics. The different MOIs being inferred simultaneously directly impact the selection of run points.

In various embodiments, input uncertainties may include airfoil heights, manufacturing tolerances, and/or airfoil widths, where turbine blade design improvement is desirable. In various embodiments, MOIs related to a computational blade design example may include statistics of outputs of the code/experiment. The MOIs may include tail probability of blade efficiency, max value of stress, average values of stress, and/or variance. In various embodiments, selecting a sequence of input queries aids in determining accurate values for these MOIs. In various embodiments, the MOIs may be defined by a user.

Figure 2 is a block diagram of a device of the system of Figure 1, in accordance with one embodiment. Referring now to Figure 2, exemplary components in the device 200 in accordance with aspects of the present disclosure include, for example, a database 210, one or more processors 220, at least one memory 230, and a network interface 240. In aspects, the device 200 may include a graphical processing unit (GPU) 250, which may be used for processing machine learning network models.

Database 210 can be located in storage. The term "storage" may refer to any device or material from which information may be capable of being accessed, reproduced, and/or held in an electromagnetic or optical form for access by a computer processor. Storage may be, for example, volatile memory such as RAM, non-volatile memory, which permanently holds digital data until purposely erased, such as flash memory, magnetic devices such as hard disk drives, and optical media such as a CD, DVD, Blu-ray Disc™, or the like.

In various aspects, data may be stored on device 200, including, for example, user preferences, historical data, and/or other data. The data can be stored in database 210 and sent via the system bus to processor 220.

As will be described in more detail later herein, processor 220 executes various processes based on instructions that can be stored in the server memory 230 and utilizing the data from database 210. With reference also to Figure 1, a request from a user device, such as a mobile device or a client computer, can be communicated to the server through the server's network interface 240. The illustration of Figure 2 is exemplary, and persons skilled in the art will be understood by other components that may exist in a controller 200. Such other components are not illustrated in Figure 2 for clarity of illustration.

Figure 3 is a flow diagram of a machine learning network method 300, in accordance with one embodiment. In various embodiments, the method 300 may be performed/run a number of iterations in order to achieve a desired confidence level outcome. At block 310, a small initial design of experiments (DOE) (e.g., the training iterations for machine learning) is implemented.

In various embodiments, at block 310, experimental runs may be performed at different values of, for example, airfoil height and/or airfoil width. Code outputs may be recorded for values of efficiency and/or pressure of the blade.

In various embodiments, a run may denote a data point, (e.g., a value of the inputs parameter(s) and the corresponding value of the output(s)). The inputs for initial runs may be selected using a DOE such as Optimal Latin Hypercube (OLH). In various embodiments, the number of initial runs may be a user input. The number of run points, values of airfoil height and width, for example, may be modified at each step/iteration.

The input uncertainty, in various embodiments, may be defined by the user. For example, it could represent manufacturing tolerances around a nominal value for the height and width of the airfoil. This may be converted to a probability distribution, like a normal or uniform probability distribution.

Once the initial runs are done, the initial data-structure may be used to create a surrogate model linking input to output. In various embodiments, the input or multiple inputs for running the computational model that are the most informative about the MOIs may be identified.

Information gain is then computed (block 320). In various embodiments, the information gain may be computed in accordance with the following equation:

$$[I(Q[f(x)])] , \qquad\qquad \text{Equation (1)},$$

where I denotes the value of the computed information gain, Q is the statistic which can be an operator like the expectation, tail probability, variance, etc. ...., f(x) denotes the underlying function or physical process that is modeled by the expensive simulation or experiment and x denotes the operational and design inputs to the system. In various embodiments, for example, f(x) may model a physical process with an input variable x that generates output values f(x). Q[] may provide statistics for output values of an underlying function f(x) when input variable x is varied. In various embodiments, I() may denote the information gain based on the statistics provided by Q[].

As mentioned above, information gain may be computed in the MOIs in accordance with Equation 1 above as function of the input parameters. Input parameters are denoted by x. In order to achieve this, the probabilistic surrogate model and its capability to be evaluated rapidly across the input space may be utilized to allow the computation of the current estimates of the MOIs.

The probabilistic quantification of the uncertainties in inputs may be used (e.g., described below at block 413) to calculate the average value of information gain, which can be approximated by computing a difference in the apriori and aposteriori probabilistic distributions of the metrics of interest. The information gain is calculated as a difference in accordance with, for example, the equations shown below in block 414 and for which further detail is provide below, which in various embodiments depicts the probabilistic representation of all the metrics of interest Q1 through Qm conditioned on a dataset observed, and the probabilistic representation of all the metrics of interest Q1 through Qm conditioned on the dataset observed, values of potential run points denoted by the x̃ and a probable unobserved value of the performance output at that run point denoted by the ȳ. In various embodiments, the run points may be selected by optimizing or maximizing the value of the information gain formulation.

In various embodiments, once this information gain is formulated/computed, it can be optimized using any optimizer like gradient descent, BFGS, to return the set of input candidates that have maximum information gain. An example approach for maximizing information gain is to use the space-filling grid of points using an OLH type DOE method. The information gain at each such candidate is evaluated and the gains that correspond to the maximum values of the information gain are selected.

When selecting multiple points to run in parallel, the multiple points may be selected by looking at the value of the information gain therein, and also separated by distance. The code may be run at the selected 5 values of the height and width of airfoil and record the values of the two outputs (e.g., efficiency and pressure). These units (e.g., outputs) may be added to the initial data the process repeated until the budget is exhausted or if by visual inspection or meeting some domain knowledge based threshold value the values and uncertainty of the metrics is acceptable.

If the iterations provide the desired outcome level (block 330) for stopping the criterion input, then the method accepts the outputs (block 350). In various embodiments, the runs points (inputs) query the code to get the values of blade efficiency and/or pressure distribution, for example.

Once the values of metrics (e.g., max of efficiency, tail value of pressure & uncertainty) are determined, they may be incorporated in downstream analysis/application (e.g.,pricing quotes for an airline customer around the tail probability and/or blade efficiency). The uncertainty around the estimate is a representation of the confidence the model has around it.

If the iterations do not provide the desired outcome level (block 330) for stopping the criterion input, then the intelligently selected run points (e.g., points that are expected to have a high information gain) are added to the observed data and the method reverts to block 320. In block 340 EIG[I]stands for expected information gain, and is the average approximated value of the Information gain I.

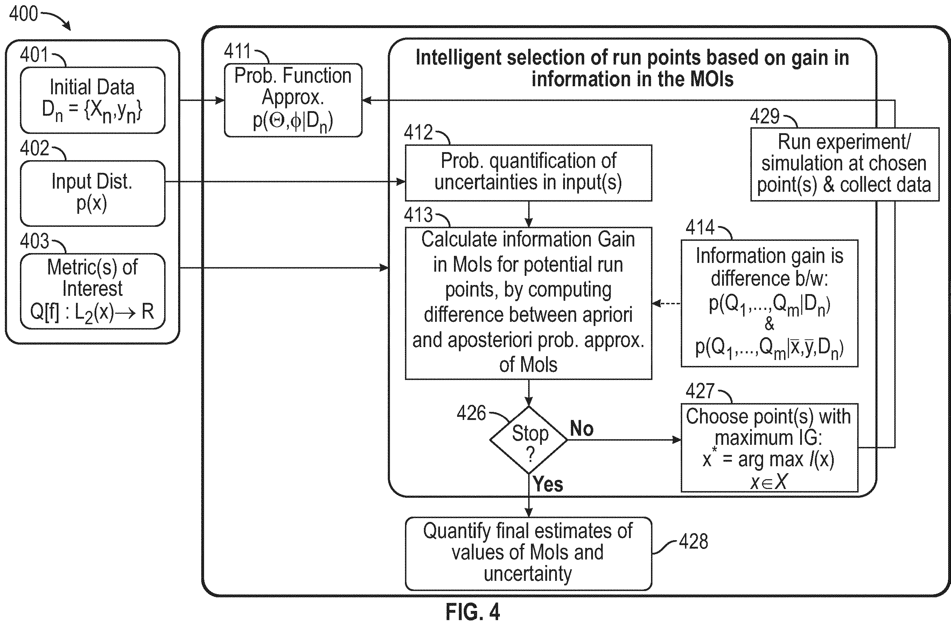

Figure 4 is a flow diagram of a method 400 of performing rapid inference and quantification, in accordance with one embodiment. In various embodiments, method 400 may perform the information gain described above at block 330 of Figure 3. In various embodiments, $X_n$ may relate to x described above in FIG. 3, (e.g., $y_n = f(\mathbf{x}_n)$). In various embodiments, p(x) may relate to the distribution of the values of x. In various embodiments, information gain may relate to I above in FIG. 3, for example, a difference in entropy, computed on a priori and a posteriori data. Accordingly, in various examples, information gain computes a reduction in entropy, providing information relating to which information gain is maximum (e.g., maximum reduction in entropy).

At block 401, initial data is utilized (e.g., $D_n = \{X_n, y_n\}$). At block 402, the input manufacturing and operation distribution $p(x)$ is utilized, and at block 403, the quantity of interest is utilized (e.g., $Q|f| : L_2(X) \rightarrow R$). In various embodiments, Q|f| is a statistical operator such as statistical expectation, variance, tail probability, etc., and f is a real valued function that takes in a vector valued input x.

In various embodiments, $D_n$ denotes dataset with values of the inputs ($X_n$)at which experiments/expensive simulations have been run, and the corresponding values of the performance output ($y_n$). The letter *n* denotes the number of such experiments/runs/iterations. The information from blocks 401, 402 and 403 are input into blocks 411, 412 and 413, respectively. Block 411 performs, in various embodiments, a probabilistic functional approximation. In various embodiments, the probabilistic functional approximation may be performed in accordance with the following: $p(\Theta, \phi|Dn)$ or $p(f(x) \mid D_n)$, where *p* represents a probabilistic quantification, like a probability distribution, of an argument. This probabilistic approximation may allow analytical samples of the underlying function to be taken.

At block 412, the probabilistic quantification of the uncertainties in inputs is used at block 413 to calculate the average value of information gain, which can be approximated by computing a difference in the apriori and aposteriori probabilistic distributions of the metrics of interest.

At block 414, the information gain is calculated as a difference in accordance with, for example, the equations shown in block 414, which in various embodiments depicts the probabilistic representation of all the metrics of interest $Q_1$ through $Q_m$ conditioned on a dataset observed, and the probabilistic representation of all the metrics of interest $Q_1$ through $Q_m$ conditioned on the dataset observed, values of potential run points denoted by the $\tilde{\mathbf{x}}$ and a probable unobserved value of the performance output at that run point denoted by the $\tilde{\mathbf{y}}$. In various embodiments, the run points may be selected by optimizing or maximizing the value of the information gain formulation above.

At block 426, if enough calculations are performed to meet a criteria for acceptable performance, the method may stop and proceed to block 428, wherein the quantification of uncertainty is determined and the final estimates of values of MOIs are quantified in block 428.

If enough calculations are not performed at block 426, then the method proceeds to block 427 wherein a point is chosen with a maximum values of the information gain and the method proceeds to block 429. In various embodiments, arg max denotes the real value of the run point that corresponds to the highest value of the "information gain" calculation I(x).

At block 429, experiments/simulations are performed at the chosen points from block 427 and data is collected for feeding back into block 411 for further analysis.

The aspects disclosed herein are examples of the disclosure and may be embodied in various forms. For instance, although certain aspects herein are described as separate aspects, each of the aspects herein may be combined with one or more of the other aspects herein. Specific structural and functional details disclosed herein are not to be interpreted as limiting, but as a basis for the claims and as a representative basis for teaching one skilled in the art to variously employ this disclosure in virtually any appropriately detailed structure.

For example, the design of the shape of turbine blades in order to achieve critical values of key metrics like max. value of the pressure distribution, tail value of rated efficiency, for example, may be important metrics to aid in the design of the blades. Described above are systems and methods for determining these values for use in design of turbine blades, for example.

The phrases "in an aspect," "in aspects," "in various aspects," "in some aspects," or "in other aspects" may each refer to one or more of the same or different aspects in accordance with this disclosure.

Further aspects of the present disclosure are provided by the subject matter of the following paragraphs.

A system for intelligent selection of inputs for inference and quantification of uncertainty for active learning in a model includes a processor and a memory including instructions which, when executed by the processor, cause the system at least to perform computing an information gain by combining one or more metrics of interest and uncertainties in the inputs using information compression based on a first set of data as one or more pairs of values of inputs and outputs; selecting one or more of the inputs, with a potential information gain higher than other inputs, to query the model and record values of one or more of the outputs; computing, by the model, a measurement of performance outputs based upon the first set of data; estimating the metrics of interest performance and quantifying the uncertainty associated with the estimation of the metrics of interest performance; updating the model based upon the estimated metrics of interest performance and quantification of the associated uncertainty; and outputting the estimated metrics of interest performance and quantification of the associated uncertainty for a change to a process based upon the estimated metrics of interest performance and quantification of the associated uncertainty.

The system according to any preceding clause, wherein the first set of data includes manufacturing tolerances.

The system according to any preceding clause, wherein the manufacturing tolerances are uncertainties associated with one or more input values.

The system according to any preceding clause, wherein the one or more outputs are results of a simulation.

The system according to any preceding clause, wherein the metrics of interest performance includes an engine performance output.

The system according to any preceding clause, wherein the engine performance output includes a mechanical power of the engine.

The system according to any preceding clause, wherein the engine performance output includes a maximum efficiency of the engine.

The system according to any preceding clause, wherein the first set of data includes tabular data.

The system according to any preceding clause, wherein the first set of data includes design of experiment (DOE) points.

The system according to any preceding clause, wherein the first set of data includes measurements of engine performance output.

The system according to any preceding clause, wherein the one or more metrics of interest include one or more of the outputs.

A processor-implemented method for intelligent selection of inputs for rapid inference and quantification of uncertainty for arbitrary statistics of expensive functions using active learning in a model includes: computing an information gain by combining one or more metrics of interest and uncertainties in the inputs using information compression based on a first set of data as one or more pairs of values of inputs and outputs; selecting one or more of the inputs, with a potential information gain higher than other inputs, to query the model and record values of one or more of the outputs; computing, by the model, a measurement of performance outputs based upon the first set of data; estimating the metrics of interest performance and quantifying the uncertainty associated with the estimation of the metrics of interest performance; updating the model based upon the estimated metrics of interest performance and quantification of the associated uncertainty; and outputting the estimated metrics of interest performance and quantification of the associated uncertainty for a change to a process based upon the estimated metrics of interest performance and quantification of the associated uncertainty.

The processor implemented method according to any preceding clause, wherein the first set of data includes manufacturing tolerances.

The processor implemented method according to any preceding clause, wherein the manufacturing tolerances are uncertainties associated with one or more input values.

The processor implemented method according to any preceding clause, wherein the one or more outputs are results of a simulation.

The processor implemented method according to any preceding clause, wherein the metrics of interest performance includes an engine performance output.

The processor implemented method according to any preceding clause, wherein the engine performance output includes a mechanical power of the engine.

The processor implemented method according to any preceding clause, wherein the engine performance output includes a maximum efficiency of the engine.

The processor implemented method according to any preceding clause, wherein the first set of data includes tabular data.

The processor implemented method according to any preceding clause, wherein the first set of data includes design of experiment (DOE) points.

A processor-implemented method for intelligent selection of inputs for inference and quantification of uncertainty for active learning in a model, the method comprising: computing an information gain by combining one or more metrics of interest and uncertainties in the inputs using information compression based on a first set of data as one or more pairs of values of inputs and outputs; selecting one or more of the inputs, with a potential information gain higher than other inputs, to query the model and record values of one or more of the outputs; computing, by the model, a measurement of performance outputs based upon the first set of data; estimating the metrics of interest performance and quantifying the uncertainty associated with the estimation of the metrics of interest performance; updating the model based upon the estimated metrics of interest performance and quantification of the associated uncertainty; and outputting the estimated metrics of interest performance and quantification of the associated uncertainty for a change to a process based upon the estimated metrics of interest performance and quantification of the associated uncertainty.

The processor-implemented method of any preceding clause, wherein the first set of data includes manufacturing tolerances.

The processor-implemented method of any preceding clause, wherein the manufacturing tolerances are uncertainties associated with one or more input values.

The processor-implemented method of any preceding clause, wherein the one or more outputs are results of a simulation.

The processor-implemented method of any preceding clause, wherein the metrics of interest performance includes an engine performance output.

The processor-implemented method of any preceding clause, wherein the engine performance output includes a mechanical power of the engine.

The processor-implemented method of any preceding clause, wherein the engine performance output includes a maximum efficiency of the engine.

The processor-implemented method of any preceding clause, wherein the first set of data includes tabular data.

The processor-implemented method of any preceding clause, wherein the first set of data includes design of experiment (DOE) points.

Those skilled in the relevant art(s) will appreciate that various adaptations and modifications of the embodiments described above can be configured without departing from the scope and spirit of the disclosure. Therefore, it is to be understood that, within the scope of the appended claims, the teachings featured herein may be practiced other than as specifically described herein.

**Claims**

1. A system (100) for intelligent selection of inputs for inference and quantification of uncertainty for active learning in a model, the system comprising:

   a processor (220); and
   a memory (230) including instructions which, when executed by the processor (220), cause the system (100) at least to perform:

      computing an information gain by combining one or more metrics of interest and uncertainties in the inputs using information compression based on a first set of data as one or more pairs of values of inputs and outputs;
      selecting one or more of the inputs, with a potential information gain higher than other inputs, to query the model and record values of one or more of the outputs;
      computing, by the model, a measurement of performance outputs based upon the first set of data;
      estimating the metrics of interest performance and quantifying the uncertainty associated with the estimation of the metrics of interest performance;
      updating the model based upon the estimated metrics of interest performance and quantification of the associated uncertainty; and
      outputting the estimated metrics of interest performance and quantification of the associated uncertainty for a change to a process based upon the estimated metrics of interest performance and quantification of the associated uncertainty.

2. The system (100) of claim 1, wherein the first set of data includes manufacturing tolerances.

3. The system (100) of claim 2, wherein the manufacturing tolerances are uncertainties associated with one or more input values.

4. The system (100) of any preceding claim, wherein the one or more outputs are results of a simulation.

5. The system (100) of any preceding claim, wherein the metrics of interest performance includes an engine performance output.

6. The system (100) of claim 5, wherein the engine performance output includes a mechanical power of the engine.

7. The system (100) of claim 5 or 6, wherein the engine performance output includes a maximum efficiency of the engine.

8. The system (100) of any preceding claim, wherein the first set of data includes tabular data.

9. The system (100) of any preceding claim, wherein the first set of data includes design of experiment (DOE) points.

10. The system (100) of any preceding claim, wherein the first set of data includes measurements of engine performance output.

11. The system (100) of any preceding claim, wherein the one or more metrics of interest include one or more of the outputs.

12. A processor (220) implemented method for intelligent selection of inputs for inference and quantification of uncertainty for active learning in a model, the method comprising:

computing an information gain by combining one or more metrics of interest and uncertainties in the inputs using information compression based on a first set of data as one or more pairs of values of inputs and outputs;
selecting one or more of the inputs, with a potential information gain higher than other inputs, to query the model and record values of one or more of the outputs;
computing, by the model, a measurement of performance outputs based upon the first set of data;
estimating the metrics of interest performance and quantifying the uncertainty associated with the estimation of the metrics of interest performance;
updating the model based upon the estimated metrics of interest performance and quantification of the associated uncertainty; and
outputting the estimated metrics of interest performance and quantification of the associated uncertainty for a change to a process based upon the estimated metrics of interest performance and quantification of the associated uncertainty.

13. The processor (220) implemented method of claim 12, wherein the first set of data includes manufacturing tolerances.

14. The processor (220) implemented method of claim 13, wherein the manufacturing tolerances are uncertainties associated with one or more input values.

15. The processor (220) implemented method of any of claims 12 to 14, wherein the one or more outputs are results of a simulation.

FIG. 1

200

210

Storage

220

Processor

230

Memory

240

Network
Interface

250

GPU/FPGA

**FIG. 2**

300

310

Small initial DOE (OLH)

320

Compute information gain
$[I(Q[f(x)])]$

340

Intelligent DOE
- add DOE points
with high EIG[I]

330

Stopping
criterion
?

**No**

350

**Yes**

Outputs are accepted

**FIG. 3**

FIG. 4

Europäisches
Patentamt

European
Patent Office

Office européen
des brevets

# EUROPEAN SEARCH REPORT

**Application Number**

EP 25 15 4262

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | F. B. SMITH ET AL: "Prediction-oriented Bayesian active learning", ARXIV.ORG, CORNELL UNIVERSITY LIBRARY, 201 OLIN LIBRARY CORNELL UNIVERSITY ITHACA, NY 14853, 17 April 2023 (2023-04-17), XP091486662, DOI: 10.48550/arXiv.2304.08151 * sections 2-5 * | 1-15 | INV. G06N5/01 G06N7/01 G06N20/00 ADD. G06F30/27 |
| A | P. PANDITA ET AL: "Learning arbitrary quantities of interest from expensive black-box functions through Bayesian sequential optimal design", ARXIV.ORG, CORNELL UNIVERSITY LIBRARY, 201 OLIN LIBRARY CORNELL UNIVERSITY ITHACA, NY 14853, 16 December 2019 (2019-12-16), XP081559594, DOI: 10.48550/arXiv.1912.07366 * the whole document * | 1-15 | |
| A | P. PANDITA ET AL: "Bayesian optimal design of experiments for inferring the statistical expectation of a black-box function", ARXIV.ORG, CORNELL UNIVERSITY LIBRARY, 201 OLIN LIBRARY CORNELL UNIVERSITY ITHACA, NY 14853, 15 January 2019 (2019-01-15), XP081015982, DOI: 10.48550/arXiv.1807.09979 * the whole document * | 1-15 | TECHNICAL FIELDS SEARCHED (IPC) G06N |

The present search report has been drawn up for all claims

| Place of search | Date of completion of the search | Examiner |
|---|---|---|
| The Hague | 11 June 2025 | Douarche, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)